# EUROPEAN PATENT APPLICATION

(11) **EP 1 341 298 A1**
(43) Date of publication of application: **03.09.2003**
(21) Application number: 03250912.7
(22) Date of filing: 14.02.2003
(51) Int. Cl.: H03B 5/12, H03G 1/00, H03F 3/72, H03B 5/36

(54) **Oscillator**

(30) Priority: 20.02.2002 JP 2002043108
(71) Applicant: ALPS ELECTRIC CO., LTD., Ota-ku Tokyo 145 (JP)
(72) Inventor: Kobayashi, Hiroki, c/o Alps Electric Co., Ltd., Tokyo (JP); Ikarashi, Yasuhiro, c/o Alps Electric Co., Ltd., Tokyo (JP); Yokoyama, Hiromi, c/o Alps Electric Co., Ltd., Tokyo (JP)
(74) Representative: Kensett, John Hinton

(57) **Abstract**

An oscillator according to the present invention includes an oscillation transistor (1) functioning as an active device for oscillation, wherein a current-switching unit (5) for switching the amount of collector current of the oscillation transistor is provided between the emitter of the oscillation transistor and ground. An increased collector current causes an increased C/N ratio of an oscillation signal and a decreased collector current allows for a longer life of a battery used as a power source. Consequently, the life of a battery used in a cellular phone applicable to different systems in which different C/N ratios are required can be prolonged.

## Description

### BACKGROUND OF THE INVENTION

### 1. Field of the Invention

The present invention relates to oscillators such as voltage controlled oscillators which are used, for example, in cellular phones.

### 2. Description of the Related Art

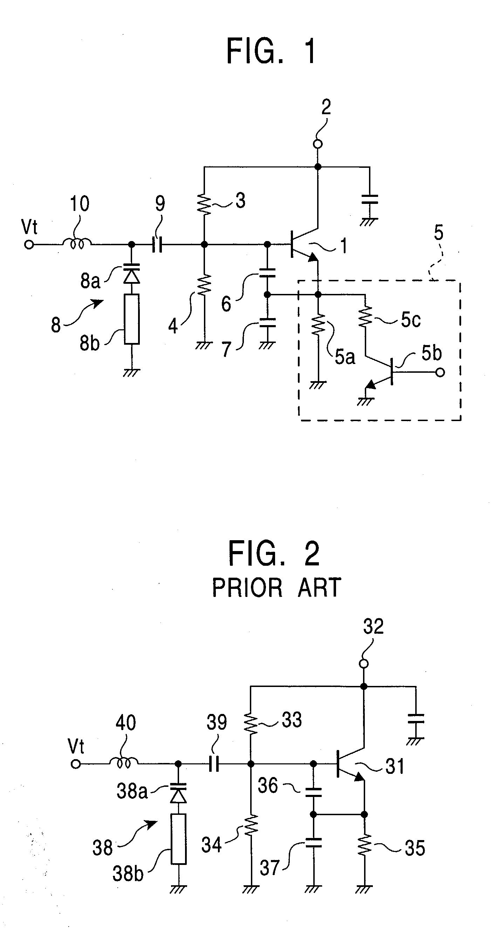

Fig. 2 shows the structure of a known voltage controlled oscillator. The collector of an oscillation transistor 31 is connected to a power terminal 32. The base of the oscillation transistor 31 is supplied with a bias voltage by base bias resistors 33 and 34 arranged in series between the power terminal 32 and ground. The emitter of the oscillation transistor 31 is connected to ground through an emitter bias resistor 35. The base bias resistors 33 and 34 and the emitter bias resistor 35 determine the collector current of the oscillation transistor 31. A feedback capacitor 36 is connected between the base and emitter of the oscillation transistor 31 and a feedback capacitor 37 is connected between the emitter of the oscillation transistor 31 and ground.

A resonance circuit 38 includes a varactor diode 38a and a strip conductor 38b which are arranged in series. One end of the strip conductor 38b is connected to the anode of the varactor diode 38a and the other end of the strip conductor 38b is grounded. The cathode of the varactor diode 38a is coupled to the base of the oscillation transistor 31 through a Clapp capacitor 39. The cathode of the varactor diode 38a is supplied with a tuning voltage Vt through a choke inductor 40.

An oscillation frequency is set by the tuning voltage and an oscillation signal is output from the base or emitter of the oscillation transistor 31.

The voltage controlled oscillator having the structure described above is used, for example, in cellular phones applicable to different systems, such as a time division multiple access (TDMA) system including a global system for mobile communications (GSM) and the like and a code division multiple access (CDMA) system including a wide code division multiple access (W-CDMA) and the like. The TDMA is a system that requires a larger carrier-to-noise (C/N) ratio than that of the CDMA. In order to achieve a sufficient C/N ratio, the C/N ratio of the oscillation signal is increased by increasing the collector current of the oscillation transistor 31. For example, the collector current of the oscillation transistor 31 is increased to approximately 15 mA.

A high collector current continuously flows through the known oscillation transistor, as described above. This high collector current causes increased power consumption, thus disadvantageously reducing battery standby time of cellular phones using always-on CDMA system.

### SUMMARY OF THE INVENTION

Accordingly, it is an object of the present invention to satisfy performance requirements of cellular phones and the like which are usable in different systems and to prolong the life of a battery as an electric power supply by reducing total power consumption.

In order to solve the above problems, an oscillator according to the present invention includes an active device for oscillation, wherein power consumption of the active device is switchable. Increased electric power causes an increased C/N ratio of an oscillation signal and decreased electric power allows for a longer life of a battery used as a power source. Thus, the life of a battery used in a cellular phone applicable to different systems in which different C/N ratios are required can be prolonged, thereby allowing for longer battery standby time by the amount of reduction in the battery drain.

The amount of current passing through the active device may be switchable. Thus, the electric power can be readily switched. Also, switching the amount of current enables a significant change in the C/N ratio.

The active device may be an oscillation transistor. A current-switching unit for switching the amount of collector current of the oscillation transistor is provided in a path for the collector current. Thus, the collector current can be readily switched.

The current-switching unit may include a first resistor and a second resistor. The first resistor is connected between the emitter of the oscillation transistor and ground. One end of the second resistor is connected to the emitter of the oscillation transistor and the other end of the second resistor is connected to ground through an open/close switch. Thus, the collector current can be switched merely by open/close control of the switch.

The switch may be an on/off switching transistor. The collector of the switching transistor is connected to the other end of the second resistor and the emitter of the switching transistor is grounded. Thus, the switching transistor can be switched on or off merely by changing the base voltage of the switching transistor.

An embodiment of the present invention will now be described, by way of example only, with reference to the accompanying diagrammatic drawings, in which:
Fig. 1 is a circuit diagram of an oscillator according to the present invention; and
Fig. 2 is a circuit diagram of a known oscillator.

### DESCRIPTION OF THE PREFERRED EMBODIMENTS

An oscillator according to the present invention will be described with reference to Fig. 1. The oscillator is a voltage controlled oscillator used in a cellular phone and the like. The collector of an oscillation transistor 1 serving as an active device for oscillation is connected to a power terminal 2 and is RF-grounded. The power terminal 2 is supplied with a voltage from a battery. The base of the oscillation transistor 1 is supplied with a bias voltage by base bias resistors 3 and 4 arranged in series between the power terminal 2 and ground. The emitter of the oscillation transistor 1 is connected to ground through a current-switching unit 5.

The base bias resistors 3 and 4 and the current-switching unit 5 determine the collector current of the oscillation transistor 1.

The current-switching unit 5 includes a first resistor 5a and a second resistor 5c. The first resistor 5a is arranged between the emitter of the oscillation transistor 1 and ground. One end of the second resistor 5c is connected to the emitter of the oscillation transistor 1 and the other end of the second resistor 5c is connected to ground through switching means 5b. The switching means 5b is a switching transistor. The collector of the switching transistor is connected to the other end of the second resistor 5c and the emitter of the switching transistor is grounded. The switching transistor is switched on when a voltage is supplied to its base. The switching transistor is switched off when no voltage is supplied to its base. A feedback capacitor 6 is connected between the base and emitter of the oscillation transistor 1 and a feedback capacitor 7 is connected between the emitter of the oscillation transistor 1 and ground. Here, the switching means 5b may be a switching diode.

A resonance circuit 8 includes a varactor diode 8a and a strip conductor 8b which are arranged in series. One end of the strip conductor 8b is connected to the anode of the varactor diode 8a and the other end of the strip conductor 8b is grounded. The cathode of the varactor diode 8a is coupled to the base of the oscillation transistor 1 through a Clapp capacitor 9. The cathode of the varactor diode 8a is supplied with a tuning voltage Vt through a choke inductor 10.

As described above, the voltage controlled oscillator is a Colpitts oscillator having a common collector configuration. An oscillation frequency is set by the tuning voltage and an oscillation signal is output from the base or emitter of the oscillation transistor 1.

The voltage controlled oscillator having the structure described above is used, for example, in a cellular phone applicable to different systems, such as a TDMA system including a GSM and the like and a CDMA system including a W-CDMA and the like. The TDMA requires a larger carrier-to-noise (C/N) ratio of the oscillation signal than that of the CDMA.

Thus, for the TDMA system, the switching means (switching transistor) 5b of the current-switching unit 5 is switched on. This causes the emitter of the oscillation transistor 1 to be grounded through the first resistor 5a and the second resistor 5c. Thus, a high collector current such as approximately 15 mA can be achieved. This causes an increased C/N ratio of the oscillation signal and increased power consumption. In contrast, for the CDMA system, the switching means 5b of the current-switching unit 5 is switched off. In this case, the collector current of the oscillation transistor 1 passes only through the first resistor 5a. Thus, the collector current is reduced to approximately 6 mA. Although this reduced current causes a lower C/N ratio, this lower C/N ratio does not cause any trouble. Thus, power consumption is reduced, thereby allowing the battery drain to be reduced and the battery life to be prolonged.

In the above-described structure in which the current-switching unit 5 is connected to the emitter of the oscillation transistor 1, switching of the collector current does not significantly affect the emitter voltage of the oscillation transistor 1. Thus, the voltage between the collector and emitter of the oscillation transistor 1 is stable, which is advantageous in operation.

For switching of the power consumption of the active device for oscillation such as the transistor, for example, the voltage supplied to the collector may be switched instead of the switching of the collector current. Also, even if the collector current is switched, the present invention is not limited to the structure described above. For example, the resistance of the base bias resistor 3 or 4 may be switched.

## Claims

1. An oscillator comprising an active device for oscillation, wherein power consumption of the active device is switchable.

2. An oscillator according to Claim 1, wherein the amount of current passing through the active device is switchable.

3. An oscillator according to Claim 1 or 2, wherein the active device includes an oscillation transistor, and wherein a current-switching unit for switching the amount of collector current of the oscillation transistor is provided in a path for the collector current.

4. An oscillator according to Claim 3, wherein the current-switching unit comprises:
a first resistor connected between the emitter of the oscillation transistor and ground; and
a second resistor, one end of the second resistor being connected to the emitter of the oscillation transistor and the other end of the second resistor being connected to ground through open/close switching means.

5. An oscillator according to Claim 4, wherein the switching means comprises an on/off switching transistor, and wherein the collector of the switching transistor is connected to the other end of the second resistor and the emitter of the switching transistor is grounded.
